# NEUE EUROPÄISCHE PATENTSCHRIFT

(11) **EP 3 512 750 B2**
(45) Veröffentlichungstag und Bekanntmachung des Hinweises auf die Entscheidung über den Einspruch: **10.12.2025**
(45) Hinweis auf die Patenterteilung: 12.10.2022
(21) Anmeldenummer: 17757512.3
(22) Anmeldetag: 21.08.2017
(51) Int. Cl.: B61C 17/00, H02B 1/052, H02B 1/26, H02B 1/30, H02B 1/50, H02B 1/54, H05K 5/02, H05K 7/14, B60T 17/22, C25D 11/04

(54) **RAHMEN FÜR EINE BREMSSTEUEREINRICHTUNG EINES SCHIENENGEBUNDENEN FAHRZEUGS**
FRAME FOR A BRAKE CONTROL DEVICE OF A RAILBOUND VEHICLE
CADRE POUR UN DISPOSITIF DE COMMANDE DE FREINAGE D'UN VÉHICULE FERROVIAIRE

(30) Priorität: 16.09.2016 DE 102016117497
(43) Veröffentlichungstag der Anmeldung: 24.07.2019
(73) Patentinhaber: KNORR-BREMSE Systeme für Schienenfahrzeuge GmbH, 80809 München (DE)
(72) Erfinder: MANN, Hartmut, 85232 Bergkirchen (DE); WACH, Jörg-Johannes, 81247 München (DE); IMGRUNT, Eugen, 80992 München (DE); LAMPRECHT, Marcus, 85375 Neufahrn (DE)
(74) Vertreter: Prüfer & Partner mbB Patentanwälte · Rechtsanwälte
(86) Internationale Anmeldenummer: PCT/EP2017/071025
(87) Internationale Veröffentlichungsnummer: WO 2018/050397

(56) Entgegenhaltungen:
- EP-A2- 1 288 095
- WO-A1-2015/106803
- DE-A1- 102008 009 217
- US-A- 5 025 734
- US-A1- 2013 134 770

## Beschreibung

Die vorliegende Erfindung bezieht sich auf einen Gerüstbalken für einen Rahmen einer Bremssteuereinrichtung eines schienengebundenen Fahrzeugs.

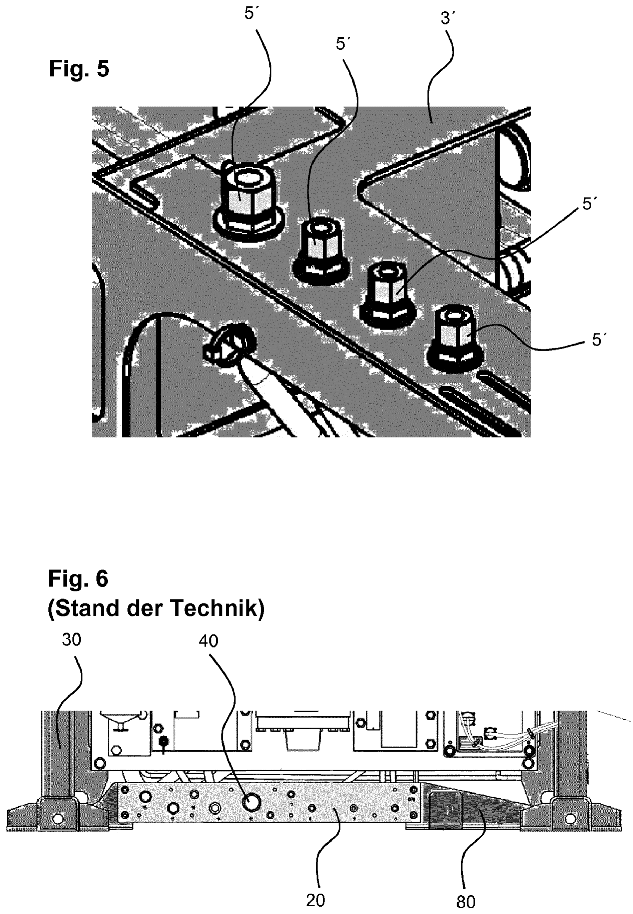

**Fig. 6** zeigt einen herkömmlichen Rahmen 30 einer pneumatischen Einrichtung 40 in Gestalt einer Bremssteuereinrichtung eines schienengebundenen Fahrzeugs. Dieser herkömmliche Rahmen 30 hat eine separat angebaute Anschlussleiste 20 mit pneumatischen Anschlüssen. Die Befestigung der pneumatischen Anschlussleiste 20 an den Rahmen 30 erfolgt mittels Haltewinkeln und Schraubenverbindungen 80. Die Nachteile dieser Bauformen sind einerseits hohe Beschaffungs- und Montagekosten, da zusätzliche Befestigungs- und Verbindungselemente 80 (z.B. Haltewinkel, Schrauben etc.) benötigt werden. Durch die Notwendigkeit der zusätzlichen Befestigungs- und Verbindungselemente 80 (z.B. Haltewinkel, Schrauben etc.) wird der Einbauraum für die pneumatischen Anschlüsse reduziert.

In diesem Zusammenhang offenbart die US 2013/0134770 A1 eine Bremssteuereinrichtung mit einem Leitungssitz, der an einem Rahmen befestigt und an den wiederum ein Ventilblock montiert ist.

In ähnlicher Weise offenbart die DE 10 2008 009217 A1 ein Bremsgerüst mit einer Standardschnittstelle zur pneumatischen Verbindung eines Hauptluftbehälters mit einem Schienenfahrzeug oder mit anderen Modulen des Bremsgerüstes.

Es ist die Aufgabe der vorliegenden Erfindung, einen Gerüstbalken für einen Rahmen einer Bremssteuereinrichtung eines schienengebundenen Fahrzeugs vorzusehen, der die vorstehend geschilderten Nachteile beseitigt. Insbesondere soll der Einbauraum für pneumatische Anschlüsse vergrößert werden und die Montage des Rahmens soll vereinfacht werden, wobei gleichzeitig die Fertigungskosten des Rahmens reduziert werden sollen.

Diese Aufgabe wird durch einen Rahmen einer Bremssteuereinrichtung eines schienengebundenen Fahrzeugs mit den Merkmalen des Anspruchs 1 gelöst. Vorteilhafte Weiterbildungen sind in den abhängigen Ansprüchen angegeben.

Der Rahmen einer Bremssteuereinrichtung eines schienengebundenen Fahrzeugs weist einen Gerüstbalken mit einer pneumatische Schnittstelle auf und ist darüber hinaus geeignet, ein tragendes Element des Rahmens zu bilden, wobei die Eigenschaft des Gerüstbalkens als tragendes Element des Rahmens dadurch verwirklicht ist, dass der Gerüstbalken eine Struktur zum Transportieren oder Heben des Rahmens aufweist. Ferner wird die Eigenschaft des Gerüstbalkens als tragendes Element des Rahmens dadurch verwirklicht ist, dass der Gerüstbalken geeignet ist, mindestens zwei Elemente des Rahmens so zu verbinden, dass der Rahmen stabil wird, wobei der Gerüstbalken durch Längsschrauben an die beiden Elemente des Rahmens geschraubt ist. Damit wird ein standardisiertes Grundkonzept für einen Rahmen ermöglicht, der für weitere Projekte verwendet werden kann.

Durch das Weglassen von zusätzlichen Befestigungs- und Verbindungselemente für die Befestigung der Anschlussleisten kann eine Kosten- und Gewichtsersparnis erzielt werden. Da die relativ schwachen Blechteile bzw. Halter für die Befestigung des Gerüstbalkens nicht mehr vorhanden sind, kann eine Erhöhung der Steifigkeit insbesondere in Fahrtrichtung erzielt werden. Zudem wird der Entwicklungsaufwand optimiert, und die Anordnung, Position und Größe der pneumatischen Anschlüsse kann mit wenig Aufwand projektspezifisch angepasst werden. Es wird eine bessere Zugänglichkeit bei Montage und Wartung erreicht, da im Anschlussbereich keine zusätzliche Rahmenstruktur zum Versteifen notwendig ist. Der Einbauraum für die pneumatischen Anschlüsse ist vergrößert, da die zusätzliche Befestigungs- und Verbindungselemente (z.B. Haltewinkel, Schrauben etc.) entfallen. Die Montage wird zudem erleichtert und benötigt keine komplizierte Vorrichtung.

Da die Gerüstbalken in der Regel mechanisch bearbeitete Teile sind, ist es möglich die engeren Toleranzen im Gesamtrahmen einzuhalten.

Das Gesamtgewicht des Rahmens kann durch die Funktionskombination, d.h. Tragende Struktur, pneumatische Schnittstelle und ggf. Transportbohrungen, reduziert werden.

Im Folgenden wird ein Ausführungsbeispiel der vorliegenden Erfindung anhand der Figuren beschrieben. Es zeigen:
- Fig. 1: einen Gesamtaufbau eines Rahmen einer Bremssteuerung eines schienengebundenen Fahrzeugs;
- Fig. 2: einen leeren Rahmen eines Ausführungsbeispiel der vorliegenden Erfindung;
- Fig. 3: einen Gerüstbalken gemäß einer Offenbarung, der nicht Teil der Erfindung ist;
- Fig. 4: einen Gerüstbalken gemäß einem Ausführungsbeispiel der vorliegenden Erfindung;
- Fig. 5: einen Abschnitt eines Rahmens des Stands der Technik; und
- Fig. 6: einen unteren Abschnitt eines Rahmens des Stands der Technik.

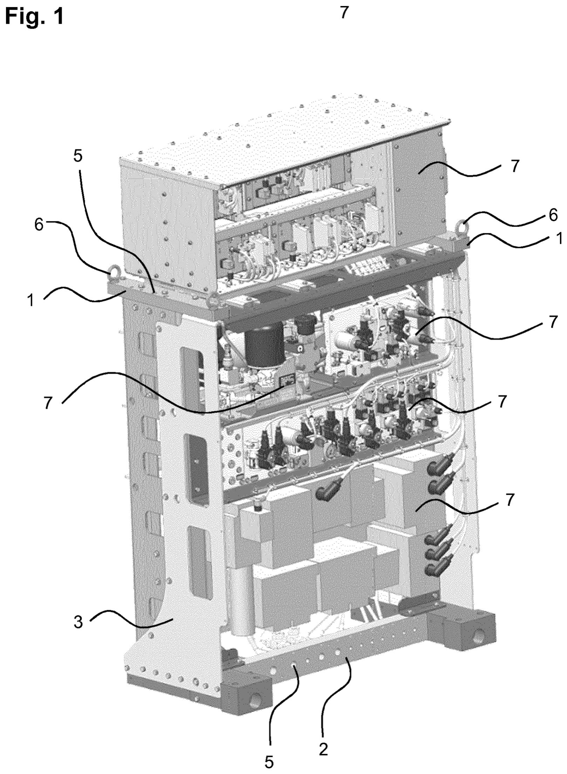

**Fig. 1** zeigt einen Gesamtaufbau eines Rahmens 3 einer Bremssteuereinrichtung eines schienengebundenen Fahrzeugs (nicht gezeigt) gemäß einem Ausführungsbeispiel der vorliegenden Erfindung. Die Bremssteuereinrichtung verfügt über mehrere pneumatische, elektrische und elektromechanische Komponenten 7, die die Bremssteuerung des schienengebundenen Fahrzeugs bewirken. Der Rahmen 3 weist mehrere Gerüstbalken 1, 2 gemäß einem Ausführungsbeispiel der vorliegenden Erfindung auf.

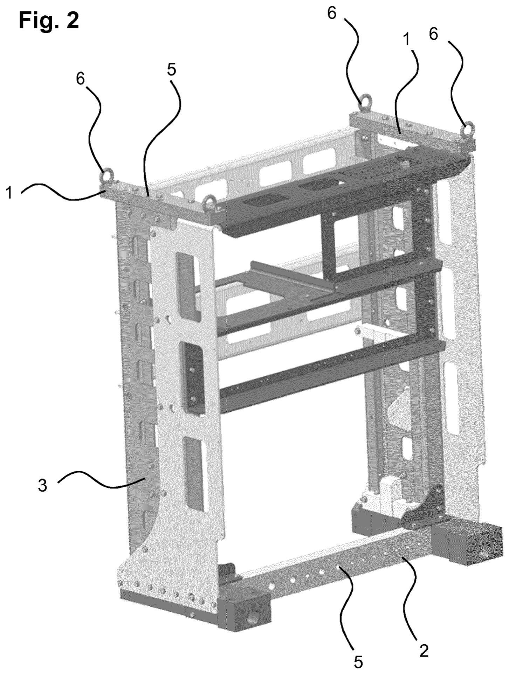

**Fig. 2** zeigt einen leeren Rahmen 3 eines Ausführungsbeispiels der vorliegenden Erfindung. Der Rahmen 3 hat im bestimmungsgemäßen Gebrauch an seiner oberen Seite zwei obere Gerüstbalken 1. Die oberen Gerüstbalken 1 sind identisch, d.h. sie haben dieselbe Form, und sie sind im Wesentlichen symmetrisch an der oberen Seite des Rahmens 3 vorgesehen. Die oberen Gerüstbalken 1 sind in Fahrtrichtung des schienengebundenen Fahrzeugs quer angeordnet. Ferner hat der Rahmen 3 im bestimmungsgemäßen Gebrauch an seiner unteren Seite exakt einen unteren Gerüstbalken 2, der in Fahrtrichtung des schienengebundenen Fahrzeugs angeordnet ist. Alternativ können auch mehrere derartige, untere Gerüstbalken 2 vorgesehen sein.

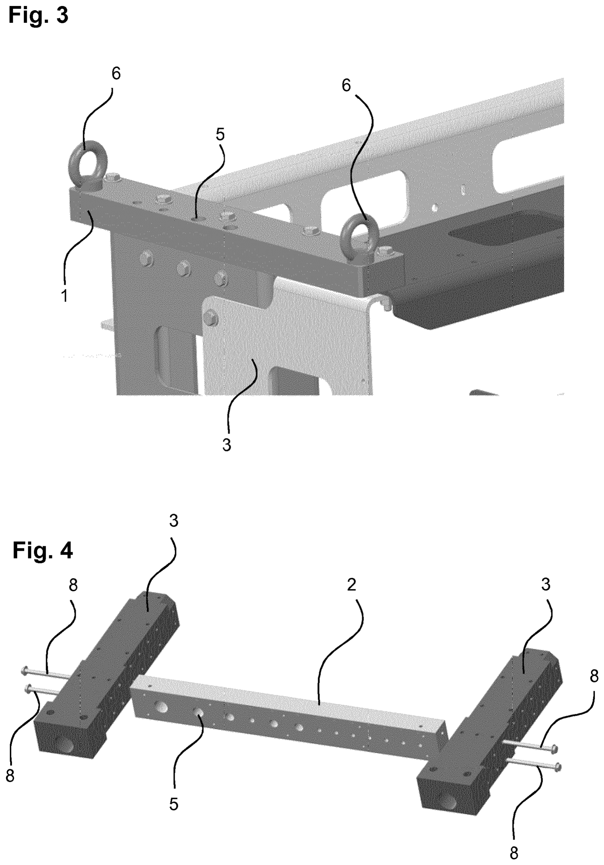

**Fig. 3** zeigt den oberen Gerüstbalken 1 gemäß einer Offenbarung, der nicht Teil der vorliegenden Erfindung ist. Offenbarungsgemäß weist der obere Gerüstbalken 1 eine pneumatische Schnittstelle 5 auf. In der dargestellten Offenbarung besteht die pneumatische Schnittstelle 5 aus Anschlussgewinden. Der obere Gerüstbalken 1 ist zusätzlich geeignet, ein tragendes Element des Rahmens 3 zu bilden. Die Eigenschaft des oberen Gerüstbalkens 1 als tragendes Element des Rahmens 3 wird zum Beispiel dadurch verwirklicht, dass der obere Gerüstbalken 1 eine Struktur 6 zum Transportieren oder Heben des Rahmens 3 aufweist. In der dargestellten Offenbarung ist die Struktur 6 zum Transportieren oder Heben des Rahmens 3 eine Transportschraube. Alternativ kann die Struktur 6 zum Transportieren oder Heben des Rahmens ein Gewinde zur Aufnahme einer solchen Transportschraube sein.

**Fig. 4** zeigt einen unteren Gerüstbalken 2 gemäß einem Ausführungsbeispiel der vorliegenden Erfindung. Erfindungsgemäß weist auch der untere Gerüstbalken 2 eine pneumatische Schnittstelle 5 auf. Im dargestellten Ausführungsbeispiel besteht die pneumatische Schnittstelle 5 aus Anschlussgewinden. Der untere Gerüstbalken 2 ist zusätzlich geeignet, ein tragendes Element des Rahmens 3 zu bilden. Die Eigenschaft des unteren Gerüstbalkens 2 als tragendes Element des Rahmens 3 wird zum Beispiel dadurch verwirklicht, dass der untere Gerüstbalken 2 geeignet ist, mindestens zwei Elemente des Rahmens 3 so zu verbinden, dass der Rahmen 3 stabil wird. Mit anderen Worten wäre der Rahmen 3, wenn der untere Gerüstbalken 2 fehlen würde, für den bestimmungsgemäßen Gebrauch nicht stabil und dementsprechend nicht zur Verwendung zugelassen. Im dargestellten Ausführungsbeispiel ist der untere Gerüstbalken 2 durch Längsschrauben 8 an die beiden (querverlaufenden) Elemente des Rahmens 3 geschraubt.

**Fig. 5** zeigt einen Rahmen 3' des Stands der Technik. In diesem Beispiel hat die pneumatische Schnittstelle 5' keine Anschlussgewinde, sondern Rohrverschraubungen, die direkt auf den Rahmen 3' geschraubt sind. Derartige Rohrverschraubungen können auch als pneumatische Schnittstellen bei den Gerüstbalken der Ausführungsbeispiele der vorliegenden Erfindung vorgsehen sein.

Insgesamt können durch die vorliegende Erfindung die folgenden Vorteile erzielt werden:
- ein Standardisiertes Grundkonzept, das für weitere Projekte verwendet werden kann
- eine Optimierung des Entwicklungsaufwandes, da Anordnung, Position und Größe der pneumatischen Anschlüsse mit wenig Aufwand projektspezifisch angepasst werden können
- Die Gerüstbalken können als tragende Rahmenstrukturen verwendet werden.
- Da die beiden Gerüstbalken mechanisch bearbeitete Teile sind, ist es möglich engere Toleranzen im Gesamtrahmen einzuhalten.
- eine Kosten- und Gewichtsersparnis durch Weglassen von Befestigungs- und Verbindungselementen für die Befestigung der Gerüstbalken
- eine Erhöhung der Steifigkeit insbesondere in Fahrtrichtung, da die schwachen Blechteile bzw. Halter für die Befestigung des unteren Gerüstbalkens nicht vorhanden sind
- einer verbesserten Zugänglichkeit bei Montage und Wartung, da im Anschlussbereich keine zusätzliche Rahmenstruktur zum Versteifen notwendig ist.
- Mehr Einbauraum für die pneumatischen Anschlüsse, da die zusätzliche Befestigungs- und Verbindungselemente (z.B. Haltewinkel, Schrauben etc.) entfallen
- Leichte und schnelle Montage ohne komplizierte Vorrichtung
- Die Anhebe- bzw. Transportbohrungen sind in dem oberen Gerüstbalken integriert.
- Der obere Gerüstbalken kann bei einer symmetrischen Ausführung rechts oder links verwendet werden.
- Reduzierung des Gesamtgewichtes durch Funktionskombination (d.h. tragende Struktur + pneumatische Anschlüsse + Transportbohrungen)

Die vorliegende Erfindung ist nicht auf die dargestellten Ausführungsbeispiele beschränkt, sondern umfasst Änderungen und Abwandlungen innerhalb des Umfangs der beigefügten Ansprüche.

### BEZUGSZEICHENLISTE

- 1: Gerüstbalken (oberer Gerüstbalken)
- 2: Gerüstbalken (unterer Gerüstbalken)
- 3, 3': Rahmen

- 5, 5': pneumatische Schnittstelle
- 6: Struktur zum Transportieren oder Heben des Rahmens
- 7: pneumatische, elektrische und elektromechanische Komponenten
- 8: Längsschraube

## Patentansprüche

1. Rahmen (3, 3') für eine Bremssteuereinrichtung eines schienengebundenen Fahrzeugs,
**gekennzeichnet durch**
mindestens einen Gerüstbalken (1, 2) für einen Rahmen (3, 3') einer Bremssteuereinrichtung eines schienengebundenen Fahrzeugs,
**dadurch gekennzeichnet, dass**
der Gerüstbalken (1, 2) eine pneumatische Schnittstelle (5, 5') aufweist und geeignet ist, ein tragendes Element des Rahmens (3, 3') zu bilden,
wobei die Eigenschaft des Gerüstbalkens (1) als tragendes Element des Rahmens (3, 3') dadurch verwirklicht ist, dass der Gerüstbalken (1) eine Struktur (6) zum Transportieren oder Heben des Rahmens (3, 3') aufweist,
die Eigenschaft des Gerüstbalkens (2) als tragendes Element des Rahmens (3, 3') dadurch verwirklicht ist, dass der Gerüstbalken (2) geeignet ist, mindestens zwei Elemente des Rahmens (3, 3') so zu verbinden, dass der Rahmen (3, 3') stabil wird,
wobei der Gerüstbalken (2) durch Längsschrauben an die beiden Elemente des Rahmens 3 geschraubt ist.

2. Gerüstbalken (1) gemäß Anspruch 1,
wobei die Struktur (6) zum Transportieren oder Heben des Rahmens (3, 3') eine Transportschraube oder ein Gewinde zur Aufnahme einer solchen Transportschraube ist.

3. Gerüstbalken (1, 2) gemäß einem der vorherigen Ansprüche,
wobei die Bremssteuereinrichtung ein Bremssteuermodul für das schienengebundene Fahrzeug ist.

4. Rahmen (3') gemäß Anspruch 1 bis 3,
wobei die pneumatische Schnittstelle (5') Rohrverschraubungen aufweist.

5. Rahmen (3, 3') gemäß Anspruch 1 bis 4,
wobei mindestens ein Gerüstbalken (1) nach Anspruch 1 im bestimmungsgemäßen Gebrauch an einer oberen Seite des Rahmens (3, 3') vorgesehen ist.

6. Rahmen (3, 3') gemäß Anspruch 5,
wobei zwei identische Gerüstbalken (1) nach Anspruch 1 im bestimmungsgemäßen Gebrauch an einer oberen Seite des Rahmens (3, 3') vorgesehen sind.

7. Rahmen (3, 3') gemäß Anspruch 6,
wobei die beiden Gerüstbalken (1) nach Anspruch 1 im Wesentlichen symmetrisch an der oberen Seite des Rahmens (3, 3') vorgesehen sind.

8. Rahmen (3, 3') gemäß einem der Ansprüche 1 bis 7,
wobei mindestens ein Gerüstbalken (2) nach Anspruch 3 im bestimmungsgemäßen Gebrauch an einer unteren Seite des Rahmens (3, 3') vorgesehen ist.

9. Rahmen (3, 3') gemäß Anspruch 8,
wobei der Gerüstbalken (2) nach Anspruch 3 im bestimmungsgemäßen Gebrauch in Fahrtrichtung des schienengebundenen Fahrzeugs angeordnet ist.

## Claims

1. A frame (3, 3') for a brake control device of a rail-bound vehicle,
**characterised by**
at least one the frame bar (1, 2) for a frame (3, 3') of a brake control device of a rail-bound vehicle,
**characterised in that**
the frame bar (1, 2) has a pneumatic interface (5, 5') and is suitable for forming a load-bearing element of the frame (3, 3'),
the characteristic of the frame bar (1) as a load-bearing element of the frame (3, 3') being achieved by providing the frame bar (1) with a structure (6) for transporting or lifting the frame (3, 3'),
the characteristic of the frame bar (2) as a load-bearing element of the frame (3, 3') being achieved by ensuring that the frame bar (1) is suitable for connecting at least two elements of the frame (3, 3') such that the frame (3, 3') is stable.

2. A frame bar (2) according to claim 1,
the structure (6) for transporting or lifting the frame (3, 3') being a transport screw or a thread to take such a transport screw.

3. A frame bar (1, 2) according to claim any one of the preceding claims,
the brake control device being a brake control module for the rail-bound vehicle.

4. A frame (3') according to claims 1 to 3,
the pneumatic interface (5') having pipe couplings.

5. A frame (3, 3') according to claims 1 to 4,
when used as intended, at least one frame bar (1) according to claim 1 being provided on an upper side of the frame (3, 3').

6. A frame (3, 3') according to claim 5,
when used as intended, there being two identical frame bars (1) according to claim 1 provided on an upper side of the frame (3, 3').

7. A frame (3, 3') according to claim 6,
the two frame bars (1) according to claim 1 being provided substantially symmetrically on the upper side of the frame (3, 3').

8. A frame (3, 3') according to any one of claims 1 to 7,
when used as intended, at least one frame bar (2) according to claim 3 being provided on an underside of the frame (3, 3').

9. A frame (3, 3') according to claim 8,
when used as intended, the frame bar (2) according to claim 3 being arranged in the direction of travel of the rail-bound vehicle.

## Revendications

1. Cadre (3, 3') d'un dispositif de commande de freinage d'un véhicule guidé sur rail,
**caractérisé par**
au moins une poutre (1, 2) d'ossature d'un cadre (3, 3') d'un dispositif de commande de freinage d'un véhicule guidé sur rail,
**caractérisé en ce que**
la poutre (1, 2) d'ossature a une interface (5, 5') pneumatique et est propre à former un élément porteur du cadre (3, 3'),
dans lequel la propriété de la poutre (1) d'ossature, comme élément porteur du cadre (3, 3'), est réalisée par le fait que la poutre (1) d'ossature a une structure (6) pour le transport ou le levage du cadre (3, 3'),
la propriété de la poutre (2) d'ossature comme élément porteur du cadre (3, 3') est provoquée par le fait que la poutre (2) d'ossature est propre à relier au moins deux éléments du cadre (3, 3'), de manière à rendre le cadre (3, 3') stable,
dans lequel la poutre (2) d'ossature est vissée par des vis longitudinales aux deux éléments du cadre 3.

2. Poutre (1) d'ossature suivant la revendication 1,
dans laquelle la structure (6) pour le transport ou le levage du cadre (3, 3') est une vis de transport ou un filetage de réception d'une vis de transport de ce genre.

3. Poutre (1, 2) d'ossature suivant l'une des revendications précédentes,
dans laquelle le dispositif de commande de freinage est un module de commande de freinage du véhicule guidé sur rail.

4. Cadre (3') suivant la revendication 1 à 3,
dans lequel l'interface (5') pneumatique a des raccords démontables.

5. Cadre (3, 3') suivant la revendication 1 à 4,
dans lequel il est prévu au moins une poutre (1) d'ossature suivant la revendication 1 en utilisation conforme aux prescriptions sur un côté supérieur du cadre (3, 3').

6. Cadre (3, 3') suivant la revendication 5,
dans lequel il est prévu deux poutres (1) d'ossature identiques suivant la revendication 1 en utilisation conforme aux prescriptions sur un côté supérieur du cadre (3, 3').

7. Cadre (3,3') suivant la revendication 6,
dans lequel les deux poutres (1) d'ossature suivant la revendication 1 sont prévues de manière sensiblement symétrique sur le côté supérieur du cadre (3, 3').

8. Cadre (3, 3') suivant l'une des revendications 1 à 7,
dans lequel au moins une poutre (2) d'ossature suivant la revendication 3 est prévue en utilisation conforme aux prescriptions sur un côté inférieur du cadre (3, 3').

9. Cadre (3, 3') suivant la revendication 8,
dans lequel la poutre (2) d'ossature suivant la revendication 3 est disposée en utilisation conforme aux prescriptions dans le sens de déplacement du véhicule guidé sur rail.
